(19) Europäisches Patentamt
European Patent Office
Office européen des brevets

(11) Veröffentlichungsnummer: **0 174 494**
**B1**

(12) # EUROPÄISCHE PATENTSCHRIFT

(45) Veröffentlichungstag der Patentschrift: **07.06.89**

(51) Int. Cl.$^4$: **G 03 C 1/68**, G 03 F 7/10

(21) Anmeldenummer: **85109826.9**

(22) Anmeldetag: **05.08.85**

(54) **Thermostabiles, durch Bestrahlung vernetzbares Polymersystem für mikroelektronische Anwendung.**

(30) Priorität: **10.08.84 DE 3429606**

(43) Veröffentlichungstag der Anmeldung: **19.03.86 Patentblatt 86/12**

(45) Bekanntmachung des Hinweises auf die Patenterteilung: **07.06.89 Patentblatt 89/23**

(84) Benannte Vertragsstaaten: **AT BE CH DE FR GB IT LI NL**

(56) Entgegenhaltungen:
**EP-A- 0 084 269**
**EP-A- 0 098 698**
**EP-A- 0 098 699**
**EP-A- 0 107 071**
**FR-A- 2 453 871**

(73) Patentinhaber: **Siemens Aktiengesellschaft Berlin und München**
**Wittelsbacherplatz 2**
**D-8000 München 2 (DE)**

(72) Erfinder: **Budde, Klaus, Dr. rer. nat.**
**Ottobrunner Strasse 5**
**D-8025 Unterhaching (DE)**
Erfinder: **Koch, Friedrich, Ing. grad.**
**Schaidlerstrasse 10**
**D-8000 München 70 (DE)**
Erfinder: **Quella, Ferdinand, Dr.-Ing.**
**Cramer-Klett-Strasse 2**
**D-8014 Neubiberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Jouve, 18, rue St-Denis, 75001 Paris, France

## Beschreibung

Die Erfindung betrifft ein Verfahren zum Herstellen von gedruckten Mehrlagenverdrahtungen unter Verwendung eines thermostabilen, durch Bestrahlung vernetzbaren Polymersystems.

Es ist bekannt, gedruckte Mehrlagenverdrahtungen durch Aufeinanderpressen von das entsprechende Leitungsbild enthaltenden Dünnschichtlaminaten mittels Klebfolien herzustellen. Die Dünnschichtlaminate und Klebfolien bilden Isolierstoffschichten zwischen den einzelnen Leiterbahnebenen. Nach Entstehung der Mehrlagen-Leiterplatten werden durch Bohrungen und anschließende Durchkontaktierungen dieser Bohrungen die Leitungsverbindungen und Kontaktstellen zwischen den einzelnen Schichten hergestellt.

Um Rißbildungen in der Kontaktschicht, in den Zwischenschichten sowie Delaminierungseffekte beim Löten oder bei Wechseltemperaturbeanspruchungen zu vermeiden, wurde das eben beschriebene Verfahren dahingehend verbessert, daß die Dünnschichtlaminate beidseitig kupferkaschiert und mit einem Fotoresistlack beschichtet werden. Dieser Lack, welcher ein Negativ- oder ein Positiv-Lack sein kann, wird mit einer entsprechenden Maske abgedeckt, belichtet und entwickelt. Die verbleibenden entwickelten Harzschichten dienen als Resist beim anschließenden Ätzvorgang für das Kupfer. Nach dem Entfernen des Kupfers durch Ätzen entsteht das gewünschte Leiterbild, auf dem bei Verwendung eines Negativ-Lackes der Fotoätzresistlack haftet. Diese Lackreste werden mit organischen Lösungsmitteln oder mechanisch entfernt und dann die nächste Lage aufgebracht.

Bei der Strukturerzeugung mittels Bestrahlung wird zwischen einem niederenergetischen Bereich (Wellenlänge größer 100 nm) und einem hochenergetischen Bereich, beispielsweise Röntgen- oder Elektronenstrahlen unterschieden. Naturgemäß steigt die Auflösung des Belichtungsverfahrens bei Verwendung von Strahlung kleinerer Wellenlänge. Wie aus einem Aufsatz von A. Ledwith aus den IEE Proceedings, Vol. 130, Pt. 1, Nr. 5, Oktober 1983, auf den Seiten 245 bis 251 zu entnehmen ist, liegen die Grenzen bei ca. 1 μm für UV-Strahlung und bei ca. 8 μm für Elektronenstrahlung.

Für den Aufbau von mikroelektronischen Bauelementen werden Leiterbahnabstände kleiner 20 μm benötigt. Damit ergibt sich, daß das verwendete Material eine niedrige Dielektrizitätskonstante besitzen muß. Wie aus einem Aufsatz von A. J. Blodgett aus dem Spektrum der Wissenschaft, September 1983, auf den Seiten 94 bis 106 bekannt ist, soll die Dielektrizitätskonstante einen Wert kleiner 3 besitzen. Aus dem gleichen Aufsatz ist zu entnehmen, daß bei hochintegrierten Bauelementen im Betrieb eine hohe thermische Dauerbelastung etwa im Bereich von 100 °C auftritt.

Aufgabe der Erfindung ist es, ein Verfahren zum Herstellen von gedruckten Mehrlagenverdrahtungen anzugeben, dessen Produkt folgende Eigenschaften aufweist :

1. Die Dielektrizitätskonstante der Isolierschichten soll kleiner 3 sein,
2. Die Dauertemperaturbeständigkeit des Mehrlagenaufbaus soll größer 100 °C sein,
3. Eine kurze Belichtungszeit für die Vernetzung des Polymersystems ist erwünscht ; möglichst kürzer als 5 Minuten bei einer Intensität von 100 $mW/cm^2$,
4. Ein Mehrlagenaufbau ohne Kupferzwischenschichten soll möglich sein.

Ein für ein solches Verfahren verwendbares Polymermaterial, welches sowohl die geforderte hohe Auflösung und gute Strukturstabilität sowie die benötigte thermische Belastbarkeit besitzt, als auch mit den üblichen Fotolithografieprozessen problemlos zu verarbeiten ist, ist bislang nicht bekannt.

Bekannt sind aus einem Aufsatz von C. D. Eisenbach in der Zeitschrift « Angewandte Makromolekulare Chemie » 109/110 (1982) auf den Seiten 101 bis 112 Polyimidsysteme, die nach dem Aushärten zwar gute thermische Eigenschaften zeigen, aber beim Aushärten einen ca. 40 %igen Massenverlust erleiden und deshalb Strukturunschärfen erzeugen.

Desweiteren sind aus dem gleichen Aufsatz Oligochinolinsysteme bekannt, die zwar sehr gute elektrische Eigenschaften aufweisen, jedoch unempfindlich bei der Belichtung sind und zudem noch eine Eigenfärbung besitzen.

Ein strahlungsempfindlicher Kunstharzlack auf Zimtsäure Epichlorhydrin-Bisphenol A-Basis, der die der Erfindung zugrundeliegende Aufgabe zum Teil lösen könnte, ist in der Patentanmeldung P 34 24 119.1 vorgeschlagen worden.

Durch dieses Polymersystem wird eine gute Strukturauflösung und geeignete elektrische Eigenschaften erzielt ; die thermische Belastbarkeit ist jedoch nicht optimal.

Die Aufgabe wird durch ein Verfahren der eingangs genannten Art durch die Maßnahmen des kennzeichnenden Teils des Patentanspruchs 1 gelöst.

Die Verwendung eines Polymersystems, welches den oben angegebenen Anforderungen genügt, wird durch die Erfindung vorgeschlagen ; es ist gegenüber den bekannten Polymersystemen dadurch gekennzeichnet, daß es lineare Fluorpolymere mit mindestens zwei reaktiven Endgruppen pro Polymermolekül als Ausgangsstoffe für die Umsetzung mit den strahlungsempfindlichen Substanzen enthält. Dabei liegt es im Rahmen der Erfindung, daß die Ausgangsstoffe aus perfluorierten Ätherverbindungen mit den chemischen Formeln

$$X{-}CF_2O{-}(C_2F_4O)_m{-}(CF_2O)_n{-}CF_2{-}Y$$

und/oder

$$Z{-}CF_2{-}(C_2F_4O)_m{-}(CF_2O)_n{-}CF_2{-}Z$$

bestehen, wobei X bzw. Y—$CH_2OH$, —COOH, —COCl, —NCO und Z ein Isocyanat der Formel

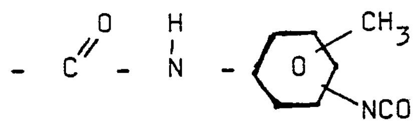

bedeuten und m und n größer als 2, vorzugsweise zwischen 5 und 20 ist. (Die Ausgangsverbindungen sind im Handel erhältlich von der Fa. Montedison).

Es ist aber ebenso möglich, daß die Ausgangsstoffe aus perfluorierten Alkanen der chemischen Formel $E{-}(CF_2)_n{-}E$ bestehen, wobei E eine Hydroxymethylengruppe ($CH_2OH$) oder Jod (J) bedeuten und n eine Zahl zwischen 3 und 25 ist. (Die Ausgangsverbindungen sind im Handel erhältlich von der Fa. Hoechst).

Die genannten lichtempfindlichen Polymere sind bekannt und werden z. B. in der EP-A-98699 beschrieben.

Zur Umsetzung zu strahlungsvernetzbaren Produkten können die perfluorierten Ausgangsstoffe direkt umgesetzt werden. Die direkte Umsetzung der fluorierten Ausgangsstoffe mit Zimtsäure, Acrylsäure oder Methacrylsäure und ihren Chloriden oder Derivaten, wie Furfurylacrylsäurechlorid ergibt Produkte, die durch UV-Strahlung härtbar sind, während die Umsetzung mit bifunktionellen, doppelbindungshaltigen Carbonsäuren, wie Maleinsäure, oder den entsprechenden Anhydriden wie Maleinsäureanhydrid zu röntgenstrahlhärtenden Produkten führt.

Zur Vergrößerung der Moleküle und zur Weiterführung der Vernetzung, die die Stabilität erhöht, ist in einer Weiterbildung des Erfindungsgedankens vorgesehen, die fluorierten Ausgangsstoffe mit den mindestens zwei reaktiven Endgruppen (zum Beispiel COCl-Gruppen) zunächst mit mehrfunktionellen, nicht strahlungsreaktiven Substanzen zu verknüpfen und im nächsten Schritt mit den strahlungsempfindlichen Substanzen umzusetzen.

Beispiele für mehrfunktionelle Substanzen, mit denen die Ausgangsstoffe umgesetzt werden können :

mehrfunktionelle Alkohole wie Glycerin oder Pentaerythrit ; substituierte Phenole wie

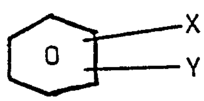

mit X = —OH und Y = 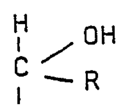 und/oder Y = —COOH

mit R = —H oder Alkylrest

oder

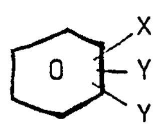

mit X = —OH und Y = 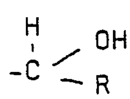 mit R = —H oder Alkylrest

oder

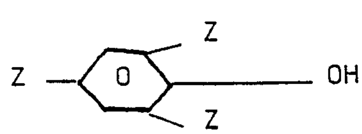

mit $Z = -CH_2OH$
oder Bisphenol — A — derivate, wie

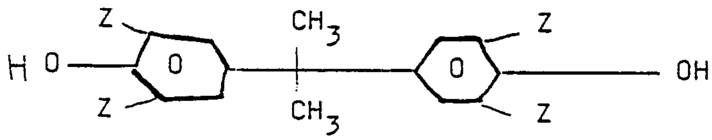

mit $Z = -CH_2OH$
oder Polymere, die ein oder mehrere Epoxidgruppen pro Molekül enthalten sowie ein oder mehrere Gruppen der Formeln —OH

oder

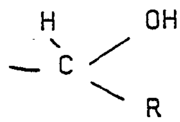

mit R = —H oder Alkylrest pro Polymerbaustein ; beispielsweise

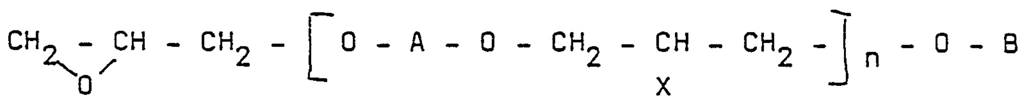

vorzugsweise mit A =

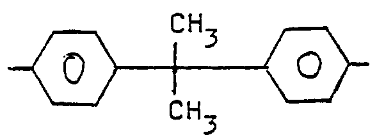

und X = —OH oder

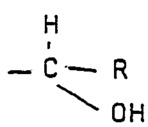

wobei R = —H oder Alkylrest

und B = —H, Alkylrest, Phenylrest, insbesondere

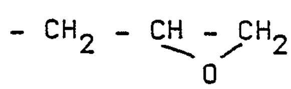

und $n \geq 2$, vorzugsweise $10 \leq n \leq 30$.

Eine weitere Möglichkeit, das gewünschte fotovernetzbare Polymer zu erhalten, ist dadurch gegeben, daß zunächst der fluorierte Ausgangsstoff mit Substanzen mit fotoreaktiven Gruppen verknüpft wird und das hierbei entstandene Produkt A in einem weiteren Schritt mit den mehrfunktionellen, fotoreaktiven Substanzen umgesetzt wird. Folgendes Ausführungsbeispiel wird angegeben :

1. Schritt :

Umsetzung des fluorierten Ausgangsstoffes mit beispielsweise Zimtsäurechlorid ergibt Produkt A.

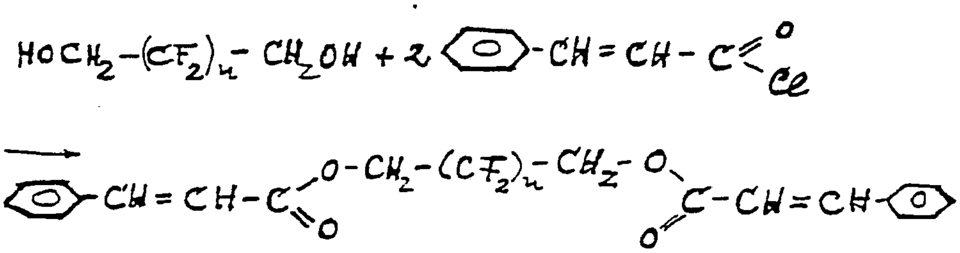

(A)

2. Schritt :

Umsetzung von A mit dem Produkt B aus 1 Mol Glycerin und 3 Mol Zimtsäure

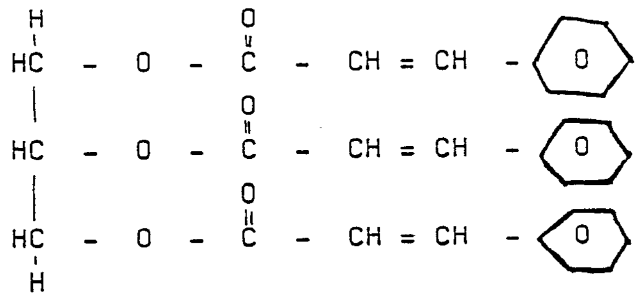

(B)

etwa im Verhältnis A : B = 10 : 1 ergibt Endprodukt mit etwa folgender chemischer Formel :

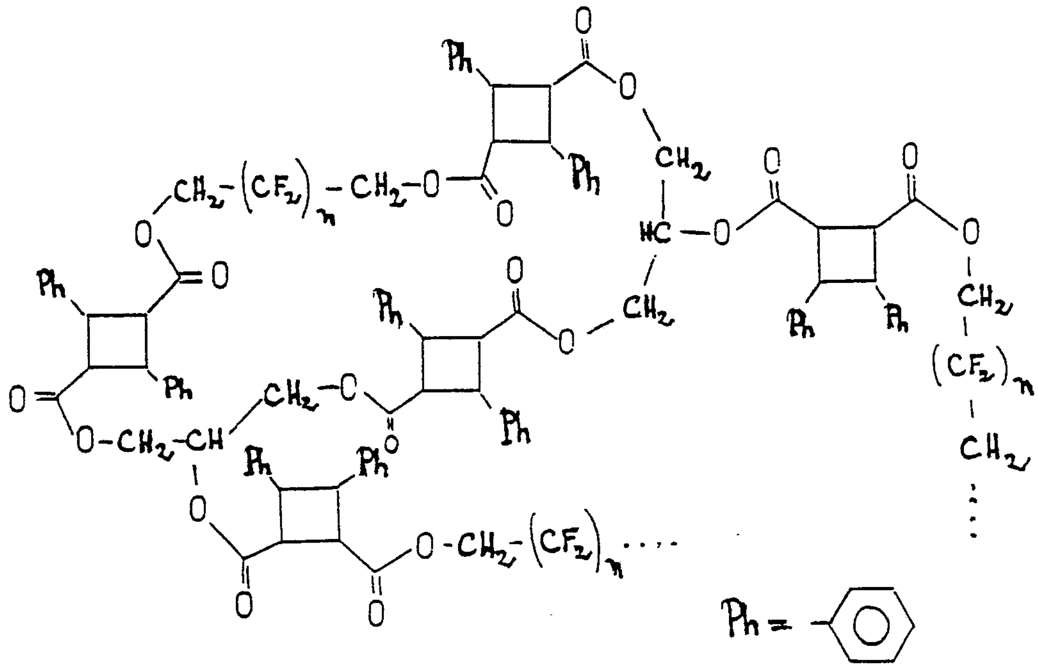

Die angegebene Formel ist nur eine von unendlich vielen Anordnungsmöglichkeiten von A und B im vernetzten Produkt. Die Variation erfolgt, weil

1) alle möglichen Kombinationen

a) A-A
b) A-B mit A oder B mit A oder B...
c) B-B

auftreten können. Das Produkt ist dreidimensional « unendlich » vernetzt.

2. Unendlich viele Stereoisomere auftreten können.

Für A = 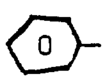 $-CH = CH - X$ und B = 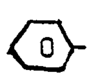 $-CH = CH - Y$

existieren für jede Cyclobutanbildung (Vernetzung) mehrere Stereoisomere :

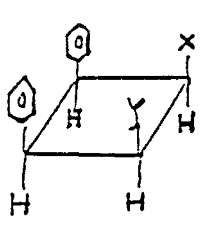 ; 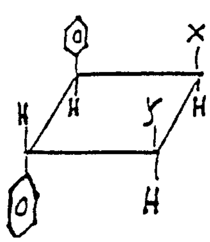 ; 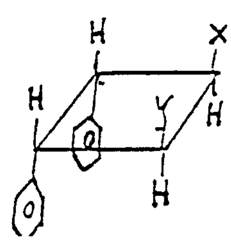 . . .

Aufgrund der verschiedenen Kombinationen unter 1) ergeben sich für das Produkt unendlich viele unterschiedliche Konformationen.

Für die Durchführung der Reaktionen werden bekannte Verfahren zur Umsetzung von Epoxiden oder Kondensationsreaktionen verwendet, wie sie zum Beispiel in D. Braun « Praktikum der Makromolekularen Chemie », Verlag Hüthig und Wepf, beschrieben sind.

Das erfindungsgemäße Produkt läßt sich als Folie durch Verpressen/Laminieren, bevorzugt im Temperaturbereich von 40 bis 200 °C, mit oder ohne metallische Zwischenschichten, insbesondere aus Kupfer oder Kupferlegierungen bestehend, oder als gelöster Stoff in geeigneten Lösungsmitteln zur Beschichtung von insbesondere aus Metallfolien oder -blechen bestehenden Substraten durch Lackieren, Spritzen oder Tauchen, und/oder mit weiteren, als Fotoinitiatoren oder Stabilisatoren wirkenden Zusätzen verarbeiten (mit Fotoinitiatoren für Cinnamate, beispielsweise Michlers Keton, für Acrylate, zum Beispiel Benzoinderivate in Konzentrationen von etwa 1 bis 5 % ; mit Stabilisatoren beispielsweise Hydrochinon in Konzentrationen von etwa 0,1 bis 0,5 %).

Im folgenden soll anhand eines Ausführungsbeispiels das erfindungsgemäße Verfahren zur Herstellung einer Mehrlagenverdrahtung beschrieben werden. Dabei ergibt sich, bedingt durch die Eigenschaft des Materials, ein neuer Aufbau für den mit elektrischen Leitungsbahnen und elektrischen Durchkontaktierungen versehenen Isolierstoffträger.

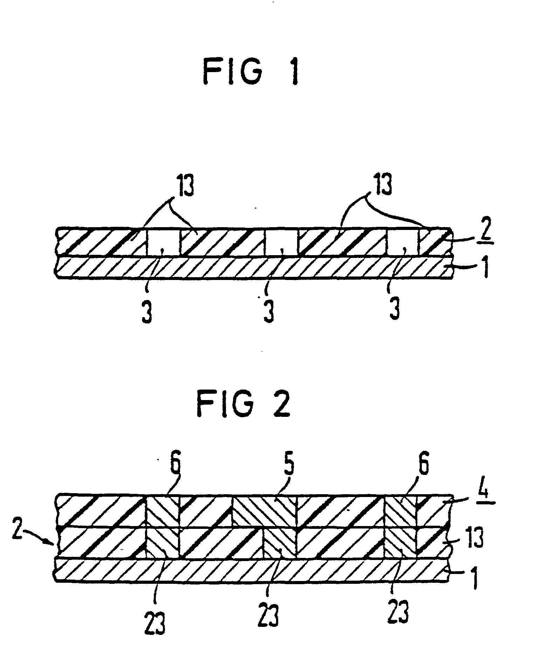

Die Figuren 1 und 2 zeigen dabei im Schnittbild die erfindungswesentlichen Verfahrensschritte.

Figur 1 :

Als Träger wird eine Kupferfolie 1 verwendet, auf die eine Schicht 2 des fotovernetzbaren Isolierstoffes gemäß der Lehre der Erfindung (nach Zusatz von zum Beispiel Michlers Keton als Sensibilisator) durch Tauchen oder Sprühbelacken, beispielsweise in einer Schichtdicke von 5 bis 20 µm aufgebracht wird. Die Schicht 2 wird vorzugsweise mit UV-Strahlung in der Weise belichtet und entwickelt, daß die in ihr einzufügenden Durchkontaktierungen, das heißt die Anschlußpunkte der Chips als Durchbrechungen 3 in der Isolierstoffschicht 2 entstehen. Die Bestrahlung erfolgt im Kontakt- oder Projektionsverfahren unter Verwendung einer Maske (nicht abgebildet), die den Bereich der Durchbrechungen 3 der Schicht 2 abdeckt (Negativlack). Die abgedeckten Teile (3) werden anschließend mit einem entsprechenden Lösungsmittel, wie zum Beispiel Chlorfluorkohlenstoff (zum Beispiel Freon ® der Firma DuPont oder Fluorinert ® der Firma 3M) herausgelöst, während bei den belichteten Teilen 13 der Schicht 2 eine chemische Vernetzung eingetreten ist, die eine Lösung verhindert, so daß diese Teile 13 als Isolierstoffschicht verbleiben. Nach der Herstellung der Durchbrechungen 3 für die dieser ersten Isolierstoffschicht 2 (13) zugeordneten Durchkontaktierungen werden die Durchbrechungen 3 im Zusammenhang mit der als Träger dienenden Kupferfolie 1 mittels galvanischer Metallisierung mit einem elektrisch gut leitenden Material, beispielsweise Kupfer, ausgefüllt (23 in Figur 2).

Figur 2 :

Anschließend wird auf die die Durchkontaktierungen 23 enthaltende Isolierstoffschicht 13 eine weitere Schicht 4 des fotovernetzbaren Isolierstoffes nach der Lehre der Erfindung in der gleichen Weise wie bei Figur 1 beschrieben aufgebracht, in welche Leitungsbahnen 5 und weitere Durchkontaktierungen 6 eingefügt werden. Die Belichtung und Entwicklung der Schicht 4 erfolgt ebenfalls wie bei Figur 1 beschrieben. Außer den Durchbrechungen (6) für die Durchkontaktierung, die mit den Durchkontaktierungen 3 der ersten Isolierstoffschicht 2 (13) zur Auflage kommen, werden in der zweiten Isolierstoffschicht 4 grabenförmige Aussparungen 5 für die gewünschten Leitungsbahnen erzeugt, wobei diese Aussparungen 5 so angeordnet sind, daß mindestens eine Durchkontaktierung 23 der ersten Isolierstoffschicht (2, 13) in eine Aussparung 5 hineinragt. Zum Aufbau der Leitungsbahnen werden die Aussparungen 5 durch Galvanisieren mit einer Metallisierung versehen. Weitere Durchkontaktierungen und Leiterbahnen können dann durch entsprechende Wiederholung der vorstehend beschriebenen Herstellungsstufen aufgebracht werden. Zwischen den einzelnen Lagen werden die Anordnungen einem Trocknungs- und/oder thermischen Aushärteprozeß im Bereich von 40 bis 150 °C unterzogen.

Der neuartige Verdrahtungsaufbau erfordert keine Kupferzwischenschichten. Die geforderte hohe thermische Belastbarkeit ist gegeben ; die Verarbeitung mit den bekannten Resisttechniken ist problemlos. Dadurch vereinfacht sich nicht nur das Verfahren zur Herstellung eines solchen Aufbaues, sondern auch die Zuverlässigkeit in bezug auf die elektrischen Daten.

Aus diesem Grunde und auch wegen der sehr niedrigen Dk und der guten Auflösung ist das Polymersystem bestens geeignet als hochtemperaturbeständiger Negativlack bei der Herstellung von integrierten Halbleiterschaltungen in VLSI-Technik (= Very Large Scale Integration ; Technik für höchstintegrierte Schaltungen mit Strukturbreiten von ca. 1 µm), bei denen die Erzeugung maßgetreuer Mikrostrukturen bzw. -muster von großer Bedeutung ist. Die Belichtungszeit ist mit den auf diesem Gebiet einsetzbaren Lacksystemen vergleichbar. Nähere Einzelheiten sind aus dem Aufsatz von C. D. Eisenbach aus der Zeitschrift « Die Angewandte Makromolekulare Chemie » 109/110 (1982) auf den Seiten 101 bis 112 zu entnehmen.

**Patentansprüche**

1. Verfahren zum Herstellen von gedruckten Mehrlagenverdrahtungen unter Verwendung eines thermostabilen, durch Bestrahlung vernetzbaren Polymersystems, dadurch gekennzeichnet, daß

a) eine, vorzugsweise aus Kupfer bestehende Metallfolie (1) mit dem durch Bestrahlung vernetzbaren Polymersystem (2) beschichtet wird,
wobei ein Polymersystem verwendet wird, welches durch Umsetzung linearer Fluorpolymere mit strahlungsempfindlichen, olefinisch ungesättigte Gruppen enthaltenden Substanzen erhalten wird,
wobei pro Fluorpolymermolekül mindestens zwei reaktive Endgruppen vorhanden sind, die mit den strahlungsempfindlichen Substanzen eine chemische Verknüpfungsreaktion eingehen und
wobei als Fluorpolymere perfluorierte Polyetherverbindungen der Formeln

$$X—CF_2O—(C_2F_4O)_m—(CF_2O)_n—CF_2—Y$$

und/oder

$$Z—CF_2—(C_2F_4O)_m—(CF_2O)_n—CF_2—Z$$

oder perfluorierte Alkane der Formel

$$E—(CF_2)_o—E$$

verwendet werden, in denen X bzw. Y je eine Gruppe $—CH_2OH$, —COOH, —COCl oder —NCO bedeuten, Z ein Isocyanat der Formel

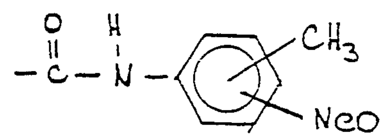

ist, E $—CH_2OH$ oder —J (Jod) darstellt, m und n größer als 2 sind und o eine ganze Zahl zwischen 3 und 25 ist,

b) die gewünschte Verdrahtungsstruktur (3) durch Belichtung und Herauslösen der unbelichteten Teile in der Polymerschicht (2) erzeugt wird,

c) das freigelegte Metall (1) durch Galvanisieren (3) verstärkt wird und

d) in der gleichen Weise weitere Lagen (4) durch Beschichtung, Strukturierung und Galvanisierung erzeugt werden.

2. Verfahren nach Anspruch 1, dadurch gekennzeichnet, daß die Bestrahlung mit UV Licht unter Verwendung von Masken im Kontakt- oder Projektionsverfahren erfolgt.

3. Verfahren nach Anspruch 1 und/oder 2, dadurch gekennzeichnet, daß als Lösungsmittel halogenierte Kohlenwasserstoffe, vorzugsweise Chlorfluorkohlenwasserstoffe (zum Beispiel Freon ® oder Fluorinert ®) verwendet werden.

4. Verfahren nach mindestens einem der Ansprüche 1 bis 3, dadurch gekennzeichnet, daß vor dem Aufbau der nächsten Lage (4, 5, 6) eine zwischenzeitliche Trocknung und/oder Temperung im Bereich von 40-150 °C durchgeführt wird.

5. Verfahren nach Anspruch 1, dadurch gekennzeichnet, daß ein Polymer verwendet wird, bei dem m und n eine Zahl zwischen 5 und 20 ist.

6. Verfahren nach mindestens einem der Ansprüche 1 bis 5, dadurch gekennzeichnet, daß die linearen Fluorpolymere mit strahlungsempfindlichen Substanzen, die aus Zimtsäure, Acrylsäure oder Methacrylsäure, sowie deren Chloriden oder Derivaten bestehen, umgesetzt werden.

7. Verfahren nach Anspruch 6, dadurch gekennzeichnet, daß Furfurylacrylsäurechlorid verwendet ist.

8. Verfahren nach mindestens einem der Ansprüche 1 bis 5, dadurch gekennzeichnet, daß die strahlungsempfindlichen Substanzen zur Umsetzung mit den Fluorpolymeren aus bifunktionellen, doppelbindungshaltigen Carbonsäuren oder den entsprechenden Anhydriden ausgewählt werden.

9. Verfahren nach Anspruch 8, dadurch gekennzeichnet, daß Maleinsäure oder Maleinsäureanhydrid verwendet ist.

10. Verfahren nach mindestens einem der Ansprüche 1 bis 9, dadurch gekennzeichnet, daß ein Polymersystem verwendet wird, bei dem die linearen Fluorpolymere sowohl mit strahlungsempfindlichen Substanzen als auch mit mehrfunktionellen, nicht strahlungsreaktiven Substanzen umgesetzt sind.

11. Verfahren zum Herstellen von gedruckten Mehrlagenverdrahtungen unter Verwendung eines Polymersystems nach Anspruch 1, dadurch gekennzeichnet, daß zur Herstellung des Polymersystems die Umsetzung der Fluorpolymere über Zwischenprodukte zunächst mit mehrfunktionellen, nicht-strahlungsreaktiven Substanzen und dann mit den strahlungsreaktiven Substanzen erfolgt.

12. Verfahren nach Anspruch 11, dadurch gekennzeichnet, daß als nicht-strahlungsreaktive Substanzen mehrfunktionelle Alkohole wie Glycerin oder Penthaerythrit verwendet werden.

13. Verfahren nach Anspruch 11, dadurch gekennzeichnet, daß als nicht-strahlungsaktive Substanzen mehrfach substituierte Phenole der chemischen Formel

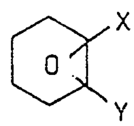

mit X = —OH und

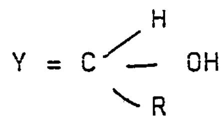

und/oder —COOH

und R = —H oder Alkylrest verwendet werden.

14. Verfahren nach Anspruch 11, dadurch gekennzeichnet, daß als nicht-strahlungsaktive Substanzen mehrfach substituierte Phenole der chemischen Formel

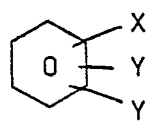

mit X = —OH,

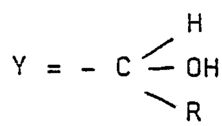

mit R = —H oder Alkylrest verwendet werden.

15. Verfahren nach Anspruch 11, dadurch gekennzeichnet, daß als nicht-strahlungsaktive Substanzen mehrfach substituierte Phenole der chemischen Formel

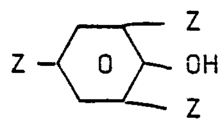

mit Z = —$CH_2OH$

verwendet werden.

16. Verfahren nach Anspruch 10, dadurch gekennzeichnet, daß als nicht-strahlungsaktive Substanzen Bisphenol-A-Derivate der chemischen Formel

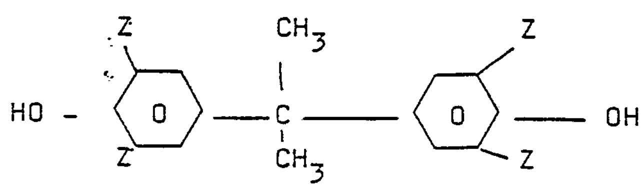

mit Z = —$CH_2OH$ verwendet werden.

17. Verfahren nach Anspruch 10, dadurch gekennzeichnet, daß die nicht-strahlungsaktiven Substanzen aus Polymeren bestehen, die ein oder mehrere Epoxidgruppen pro Molekül enthalten, sowie ein oder mehrere —OH oder

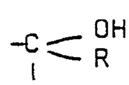

mit R = —H oder Alkylrest pro Polymerbaustein.

18. Verfahren nach Anspruch 17, dadurch gekennzeichnet, daß als nicht-strahlungsaktive Substanzen Verbindungen der chemischen Formel

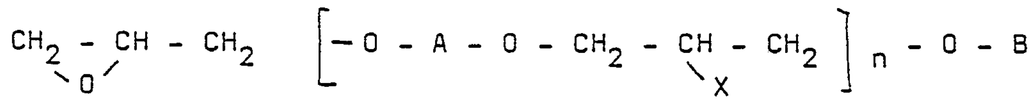

verwendet werden,

vorzugsweise mit A = 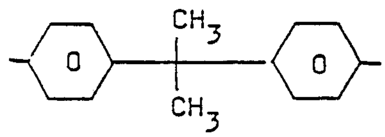

und X = —OH oder 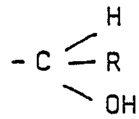 wobei R = —H oder Alkylrest

und B = —H, Alkylrest, Phenylrest, insbesondere

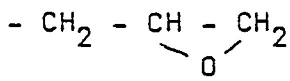 und ≥ 2, insbesondere 10 ≤ n ≤ 30.

19. Verfahren nach mindestens einem der Ansprüche 1 bis 5, dadurch gekennzeichnet, daß die Fluorpolymere zunächst mit Verbindungen mit strahlungsreaktiven Gruppen verknüpft, und danach mit anderen mehrfunktionellen strahlungsreaktiven Substanzen umgesetzt werden.

20. Verfahren nach Anspruch 1, dadurch gekennzeichnet, daß ein Polymersystem verwendet wird, zu dessen Herstellung die Fluorpolymere zunächst mit Zimtsäurechlorid umgesetzt werden und dann das entstandene Produkt A mit dem aus 1 Mol Glycerin und 3 Mol Zimtsäure entstandenen Produkt B im Molverhältnis 10 : 1 umgesetzt wird.

## Claims

1. Method for manufacturing printed multilayer wiring circuits using a thermostable irradiation-crosslinkable polymer system, characterised in that

a) a metal foil (1) preferably composed of copper is coated with the irradiation-crosslinkable polymer system (2),
a polymer system being used which is obtained by reacting linear fluoropolymers with substances containing radiation-sensitive, olefinically unsaturated groups,
at least two reactive terminal groups which enter into a chemical linking reaction with the radiation-sensitive substances being present per fluoropolymer molecule, and
the fluoropolymers used being perfluorinated polyether compounds of the formulae

$$X—CF_2O—(C_2F_4O)_m—(CF_2O)_n—CF_2—Y$$

and/or

$$Z—CF_2—(C_2F_4O)_m—(CF_2O)_n—CF_2—Z$$

or perfluorinated alkanes of the formula

$$E—(CF_2)_o—E$$

in which X or Y, respectively, each denote a $—CH_2OH$, —COOH, —COCl or —NCO group, Z is an isocyanate of the formula

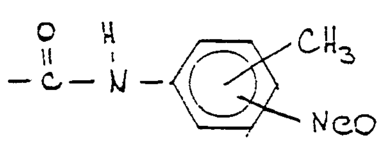

E represents $—CH_2OH$ or —I (iodine), m and n are greater than 2 and o is an integer between 3 and 25,

b) the required wiring structure (3) is produced by exposure and dissolving out the unexposed parts in the polymer layer (2),

c) the thickness of the uncovered metal (1) is increased by electroplating (3), and

d) further layers (4) are produced in the same way by coating, structuring and electroplating.

2. Method according to Claim 1, characterised in that the irradiation is carried out with UV light using masks by the contact or projection method.

3. Method according to Claim 1 and/or 2; characterised in that halogenated hydrocarbons, preferably chlorofluorohydrocarbons (for example, Freon ® or Fluorinert ®) are used as solvent.

4. Method according to at least one of the Claims 1 to 3, characterised in that, before the next layer (4, 5, 6) is built up, an interim drying and/or annealing is carried out in the range of 40-150 °C.

5. Method according to Claim 1, characterised in that a polymer is used in which m and n are. a number between 5 and 20.

6. Method according to at least one of the Claims 1 to 5, characterised in that the linear fluoropolymers are reacted with radiation-sensitive substances which are composed of cinnamic acid, acrylic acid or methacrylic acid, and also their chlorides or derivatives.

7. Method according to Claim 6, characterised in that furfurylacrylyl chloride is used.

8. Method according to at least one of the Claims 1 to 5, characterised in that the radiation-sensitive substances intended for reaction with the fluoropolymers are selected from bifunctional carboxylic acids containing double bonds, or the corresponding anhydrides.

9. Method according to Claim 8, characterised in that maleic acid or maleic anhydride is used.

10. Method according to at least one of the Claims 1 to 9, characterised in that a polymer system is used in which the linear fluoropolymers are reacted both with radiation-sensitive substances and with multi functional non-radiation-reactive substances.

11. Method for manufacturing printed multilayer witing circuits using a polymer system according to Claim 1, characterised in that, to manufacture the polymer system, the reaction of the fluoropolymers is carried out via intermediate products, first with multifunctional non-radiation-reactive substances and then with the radiation-reactive substances.

12. Method according to Claim 11, characterised in that multifunctional alcohols such as glycerol or pentaerythritol are used as non-radiation-reactive substances.

13. Method according to Claim 11, characterised in that the non-radiation-active substances used are multiplysubstituted phenols of the chemical formula

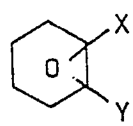

where X = —OH and

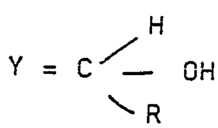

and/or —COOH

and R = —H or an alkyl radical.

14. Method according to Claim 11, characterised in that the non-radiation-active substances used are multiply-substituted phenols of the chemical formula

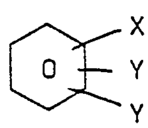

where X = —OH,

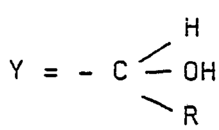

where R = —H or an alkyl radical.

15. Method according to Claim 11, characterised in that the non-radiation-active substances used are polysubstituted phenols of the chemical formula

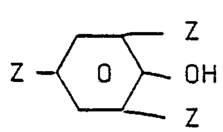

where Z = —$CH_2OH$

16. Method according to Claim 10, characterised in that the non-radiation-active substances used are bisphenol-A derivatives of the chemical formula

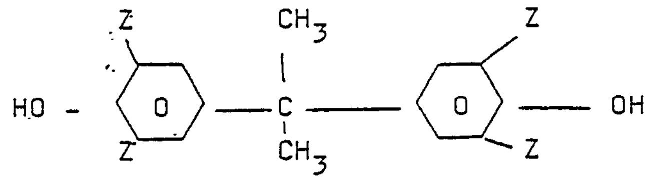

where Z = —$CH_2OH$.

17. Method according to Claim 10, characterised in that the non-radiation-active substances are composed of polymers which contain one or more epoxide groups per molecule and also one or more —OH or

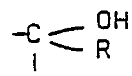

where R = —H or an alkyl radical, per polymer unit.

18. Method according to Claim 17, characterised in that the non-radiation-active substances used are compounds of the chemical formula

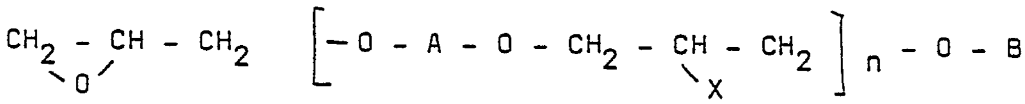

where, preferably, A = 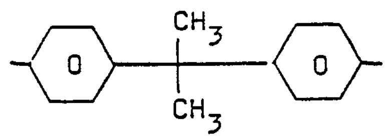

and X = —OH or 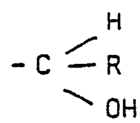 where R = —H or an alkyl radical

and B = —H, an alkyl radical or a phenyl radical, in particular

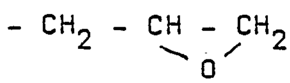

and $n \geq 2$, in particular $10 \leq n \leq 30$.

19. Method according to at least one of the Claims 1 to 5, characterised in that the fluoropolymers are first linked to compounds containing radiation-reactive groups and are then reacted with other multifunctional radiation-reactive substances.

20. Method according to Claim 1, characterised in that a polymer system is used which is manufactured by first reacting the fluoropolymers with cinnamyl chloride and then reacting the product A produced with the product B produced from 1 mol of glycerol and 3 mol of cinnamic acid in a molar ratio 10 : 1.

## Revendications

1. Procédé de fabrication de circuits imprimés multicouches, en utilisant un système de polymère thermostable et réticulable par exposition à un rayonnement, caractérisé en ce qu'il consiste :

a) à revêtir une feuille métallique (1), de préférence en cuivre, d'un système de polymère (2) réticulable par exposition à un rayonnement,

en utilisant un système de polymère qui est obtenu par réaction de polymères fluorés linéaires sur des substances contenant des groupes à insaturation oléfinique, sensibles aux rayonnements,

au moins deux groupes terminaux qui sont réactifs et qui entrent en réaction chimique de liaison avec les substances sensibles aux rayonnements étant présents pour chaque molécule de polymère fluoré et en utilisant comme polymères fluorés, des polyéthers perfluorés de formule

$$X—CF_2O—(C_2F_4O)_m—(CF_2O)_n—CF_2—Y$$

et/ou

$$Z—CF_2—(C_2F_4O)_m)—(CF_2O)_n—CF_2—Z$$

ou des alcanes perfluorés de formule

$$E—(CF_2)_o—E$$

dans lesquelles X et Y représentent chacun un groupe $—CH_2OH$, —COOH, COCl ou —NCO, Z est un isocyanate de formule

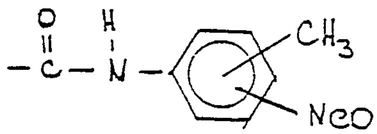

E représente $—CH_2OH$ ou —I (iode), m et n sont supérieurs à 2 et o est un nombre entier compris entre 3 et 25,

b) à produire la structure souhaitée de circuit imprimé (3) par exposition et par dissolution des parties non exposées de la couche de polymère (2),

c) à renforcer le métal dénudé (1) par dépôt par électrolyse (3), et

d) à produire de la même façon d'autres couches (4) par exposition, structuration et dépôt par électrolyse.

2. Procédé suivant la rêvendication 1, caractérisé en ce qu'il consiste à effectuer l'exposition à de la lumière ultraviolette, en utilisant des masques dans un procédé par contact ou par projection.

3. Procédé suivant la revendication 1 et/ou 2, caractérisé en ce qu'il consiste à utiliser comme solvant des hydrocarbures halogénés, de préférence des hydrocarbures chlorofluorés (par exemple un Fréon (marque déposée ou du Fluorinert (marque déposée).

4. Procédé suivant l'une au moins des revendications 1 à 3, caractérisé en ce qu'il consiste à effectuer, avant le dépôt de la couche suivante (4, 5, 6), un séchage intermédiaire et/ou un recuit entre 40 et 150 °C.

5. Procédé suivant la revendication 1, caractérisé en ce qu'il consiste à utiliser un polymère dans lequel m et n sont des nombres entiers compris entre 5 et 20.

6. Procédé suivant l'une au moins des revendications 1 à 5, caractérisé en ce qu'il consiste à faire réagir les polymères fluorés linéaires sur des substances sensibles aux rayonnements, qui sont constituées de l'acide cinnamique, de l'acide acrylique ou de l'acide méthacrylique, ainsi que de leurs chlorures ou de leurs dérivés.

7. Procédé suivant la revendication 6, caractérisé en ce qu'il consiste à utiliser le chlorure de l'acide furfurylacrylique.

8. Procédé suivant l'une au moins des revendications 1 à 5, caractérisé en ce qu'il consiste à choisir les substances sensibles aux rayonnements pour la réaction sur les polymères fluorés parmi les acides carboxyliques bifonctionnels à double liaison ou les anhydrides correspondants.

9. Procédé suivant la revendication 8, caractérisé en ce qu'il consiste à utiliser l'acide maléique ou l'anhydride de l'acide maléique.

10. Procédé suivant l'une au moins des revendications 1 à 9, caractérisé en ce qu'il consiste à utiliser un système de polymère, dans lequel les polymères fluorés linéaires réagissent à la fois sur les substances sensibles aux rayonnements et sur des substances plurifonctionnelles qui ne sont pas réactives aux rayonnements.

11. Procédé de fabrication de circuits imprimés multicouches en utilisant un système de polymères suivant la revendication 1, caractérisé en ce qu'il consiste, pour préparer le système de polymère, à effectuer la réaction des polymères fluorés, en passant par des produits intermédiaires, d'abord sur des substances plurifonctionnelles non réactives aux rayonnements, puis sur les substances réactives aux rayonnements.

12. Procédé suivant la revendication 11, caractérisé en ce qu'il consiste à utiliser comme substances non réactives aux rayonnements des polyalcools, comme la glycérine ou le pentaérythrite.

13. Procédé suivant la revendication 11, caractérisé en ce qu'il consiste à utiliser comme substances inactives aux rayonnements des phénols substitués plusieurs fois de formule chimique

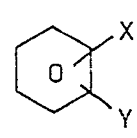

avec X = —OH et

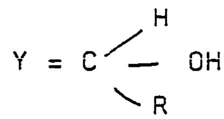 et/ou —COOH

et R = —H ou un radical alcoyle.

14. Procédé suivant la revendication 11, caractérisé en ce qu'il consiste à utiliser comme substances inactives aux rayonnements des phénols substitués plusieurs fois de formule chimique

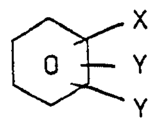 avec X = —OH,

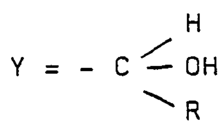

avec R = —H ou un radical alcoyle.

15. Procédé suivant la revendication 11, caractérisé en ce qu'il consiste à utiliser comme substances inactives aux rayonnements des phénols substitués plusieurs fois de formule chimique

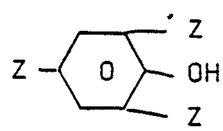 avec Z = —$CH_2OH$

16. Procédé suivant la revendication 10, caractérisé en ce qu'il consiste à utiliser comme substances inactives aux rayonnements des dérivés du bisphénol A de formule

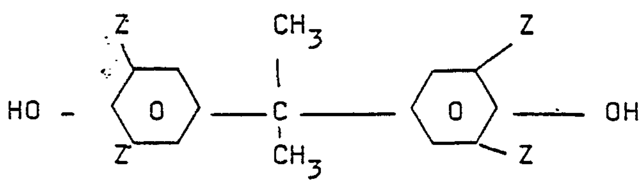

avec Z = $CH_2OH$.

17. Procédé suivant la revendication 10, caractérisé en ce que les substances inactives aux rayonnements sont des polymères qui contiennent un ou plusieurs groupes époxyde par molécule, ainsi qu'un ou plusieurs —OH ou

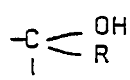

R étant H ou un radical alcoyle, par motif du polymère.

18. Procédé suivant la revendication 17, caractérisé en ce qu'il consiste à utiliser comme substances inactives aux rayonnements des composés de formule chimique

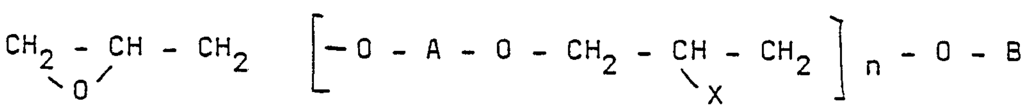

avec de préférence, A = 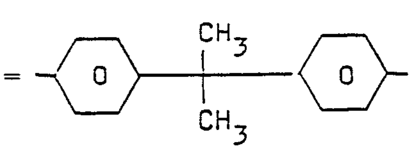

et X = —OH ou 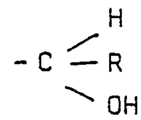 R étant H ou un radical alcoyle

et B = H, radical alcoyle, radical phényle, notamment

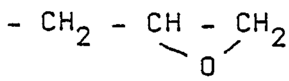

et n ⩾ 2, notamment 10 ⩽ n ⩽ 30.

19. Procédé suivant l'une au moins des revendications 1 à 5, caractérisé en ce qu'il consiste à combiner les polymères fluorés d'abord à des composés ayant des groupes réactifs aux rayonnements, puis à les faire réagir sur d'autres substances plurifonctionnelles réactives aux rayonnements.

20. Procédé suivant la revendication 1, caractérisé en ce qu'il consiste à utiliser un système de polymère pour la préparation duquel on fait réagir les polymères fluorés d'abord sur du chlorure d'acide cinnamique, puis on fait réagir dans le rapport molaire de 10 : 1 le produit A obtenu sur le produit B formé à partir d'une mole de glycérine et de 3 moles d'acide cinnamique.

FIG 1

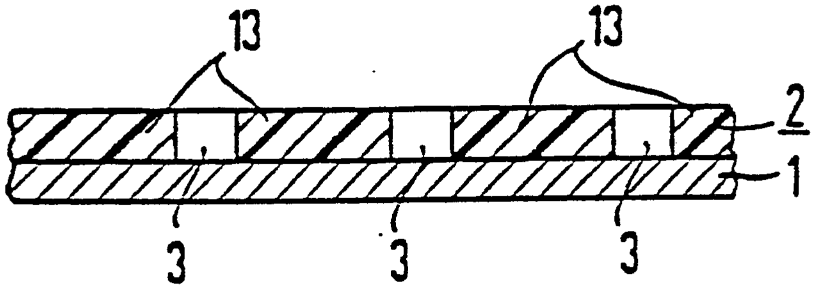


FIG 2